# EUROPEAN PATENT SPECIFICATION

(11) **EP 1 813 015 B1**
(45) Date of publication and mention of the grant of the patent: **13.02.2008**
(21) Application number: 05801152.9
(22) Date of filing: 08.11.2005
(51) Int. Cl.: H03F 3/217

(54) **ARRANGEMENT FOR AMPLIFYING A PWM INPUT SIGNAL**
ANORDNUNG ZUM VERSTÄRKEN EINES PWM-EINGANGSSIGNALS
DISPOSITIF D'AMPLIFICATION D'UN SIGNAL D'ENTREE DE MODULATION D'IMPULSIONS EN LARGEUR

(30) Priority: 12.11.2004 EP 04105729
(43) Date of publication of application: 01.08.2007
(73) Proprietor: Koninklijke Philips Electronics N.V., 5621 BA Eindhoven (NL)
(72) Inventor: NUIJTEN, Petrus, A., C., M., NL-5656 AA Eindhoven (NL); DOOPER, Lutsen, L., A., H., NL-5656 AA Eindhoven (NL)
(74) Representative: Schneider, Michael
(86) International application number: PCT/IB2005/053657
(87) International publication number: WO 2006/051478

(56) References cited:
- US-B1- 6 404 280
- US-B1- 6 768 779
- US-B2- 6 489 840
- US-B2- 6 504 427

## Description

The invention relates to an arrangement for amplifying a PWM input signal, said arrangement comprising a class D output stage, an error correction signal generator arranged to compare a PWM output signal of the class D output stage with the PWM input signal and to supply an error correction signal resulting from this comparison and reshaping means arranged to receive the PWM input signal and the error correction signal and to supply a reshaped PWM signal to the input of the class D output stage. Such arrangement is known from the international patent application publication WO98/44626.

In the above-mentioned patent application the error correction signal controls the reshaping means in which the edges of the PWM input signal are shifted to compensate for the amplitude and timing errors that occur in the class D output stage. To this end the prior art arrangement uses a limited integrator to create sloping edges on the incoming pulses. Subsequently the sloping edges are compared with the low pass filtered error correction signal and this comparison creates the square pulses with shifted edges for application to the input of the class D amplifier.

A drawback of this prior art PWM amplifier is that the maximum correction that can be obtained is limited, so that only small output stage errors can be corrected. If the slope of the edges would be made less steep, the maximum time shift and therewith the maximum correction would be larger. However, less steep edges reduce the maximum attainable pulse-width modulation and therewith the dynamic range of the amplifier.

The present invention seeks to overcome this disadvantage of the prior art PWM amplifier arrangement and the arrangement according to the invention is therefore characterized in that the reshaping means derive from the PWM input signal a width modulated triangular wave whose zero-crossings, at zero error correction signal, substantially coincide with the edges of the PWM input signal and that the triangular wave and the error correction signal drive a comparator that delivers the said reshaped PWM signal. The improvement of using the width modulated triangular wave is that the maximum possible error correction is significantly extended.

The arrangement according to the invention can be implemented in a variety of ways. For instance the triangular wave and the error correction signal may be applied to different inputs of a differential comparator or they may firstly be combined in an adder or subtracter and the combination of the two signals may then be applied to a single-input comparator for producing the reshaped PWM signal.

Also the arrangement of the present invention may be made either by analog means or by digital means. However, preferably, the arrangement is characterized in that the control loop comprising the class D output stage, the error correction generator and the comparator is implemented by analog means while the generation of the triangular wave is implemented, wholly or partly, by digital means. The analog implementation of the control loop avoids that (additional) quantization noise is produced by this loop. On the other hand the timing circuits that are required to accurately produce the triangular wave are preferably made by digital counters.

The generation of the triangular wave can be done by incrementing and decrementing a digital counter while the transitions between the incrementing phases and the decrementing phases are beforehand calculated from the edges of the PWM input signal. The output of the counter is then DA converted to obtain the triangular wave for application to the analog control loop. In this way the triangular wave is in fact a staircase triangle, which again substantially increases the quantization noise. To avoid this the arrangement according to the invention may further be characterized in that the reshaping means comprise a pulse-width modifier receiving the PWM input signal, generating a modified PWM signal whose edges substantially lie in the middle between the edges of the PWM input signal and supplying the modified PWM signal through a DA-converter to an analog integrator that provides full integration of the modified PWM signal.

This newly proposed arrangement is based on full integration instead of the limited integration of the prior art document. The modified PWM signal with the edges substantially midway between the edges of the original PWM input signal is fully integrated. This results in the triangular wave with zero-crossings that are coincident with the zero-crossings of the original PWM input signal. Subsequently the low pass filtered error correction signal is combined with the triangular wave and the combination of triangular wave and correction signal is fed to the comparator to generate the reshaped PWM signal for application to the input of the class D output stage.

To produce the modified PWM-signal the pulse-widths of the positive and the negative pulses of the input signal have to be known. This may conveniently be done if the PWM input signal is a sampled signal. In this case the pulse-width modifier is preferably arranged to determine the middle of a width modulated pulse by counting the samples during said pulse, storing the count thereby obtained and down-counting said count at twice the rate of the samples. Another embodiment of a pulse-width modifier is arranged to determine the middle of a width modulated pulse by counting the samples during said pulse, storing the count thereby obtained, dividing said count by two and then down-counting the divided count at the rate of the samples.

When a pulse of the PWM input signal has an even number of samples, the middle of the pulse can be accurately established. The number of samples in the first half of the pulse then equals the number of samples in the second half. However, when the number of samples is uneven, this is not any more the case and an error will occur in the formation of the modified PWM signal. This can be avoided when the arrangement comprises an upsampler for doubling the sampling of the PWM input signal that is applied to the pulse-width modifier. By doubling the sample rate of the input signal, each pulse will have an even number of samples and of each pulse the middle can be accurately established.

Another solution that avoids up-sampling of the input signal is characterized in that the pulse-width modulator is arranged to provide a modified PWM signal varying between +1 and -1 values, in that a splitter is provided to split the stored count into an integer part and a fractional part of 0,5 and means to use the fractional part to set the modified PWM signal to zero when the multiplied fractional part is 0,5. In this case the modified PWM-pulse will have three levels (+1,0 and-1). When this three-level pulse is subjected to full integration a width modulated triangle with flattened tops during the pulses with an odd number of samples will be produced.

The error correction signal that results from the subtraction between the PWM input signal and the PWM output signal of the class D output stage, is usually passed through a low pass filter before it is combined with the triangular wave. If this low pass filter comprises (or consists of) an integrator the integrator for the error correction signal and the integrator for the triangular wave can be replaced by one single integrator after the combination of the two signals. Then in fact the modified PWM signal and the insufficiently filtered error correction signal are firstly combined and then the combination is integrated. One analog integrator is economized and errors caused by the integrator are reduced because the integrator for the triangular wave is now within the control loop. In this case the triangular wave appears behind the integrator in combination with the error correction signal.

The invention will be described with reference to the accompanying Figures. Herein shows:
Fig. 1 a prior art arrangement for amplifying a PWM input signal,
Fig. 2 waveforms illustrating the operation of the prior art arrangement of Fig. 1,
Fig. 3 an arrangement for amplifying a PWM input signal according to the invention,
Fig. 4 waveforms illustrating the operation of the arrangement of Fig. 3,
Fig. 5 a pulse-width modifier for use in the arrangement of Fig. 3,
Fig. 6 a second arrangement for amplifying a PWM input signal according to the invention,
Fig. 7 a second pulse-width modifier for use in an arrangement according to the invention,
Fig. 8 waveforms illustrating the operation of an arrangement using the pulse-width modifier of Fig. 7 and
Fig. 9 a third arrangement for amplifying a PWM input signal according to the invention.

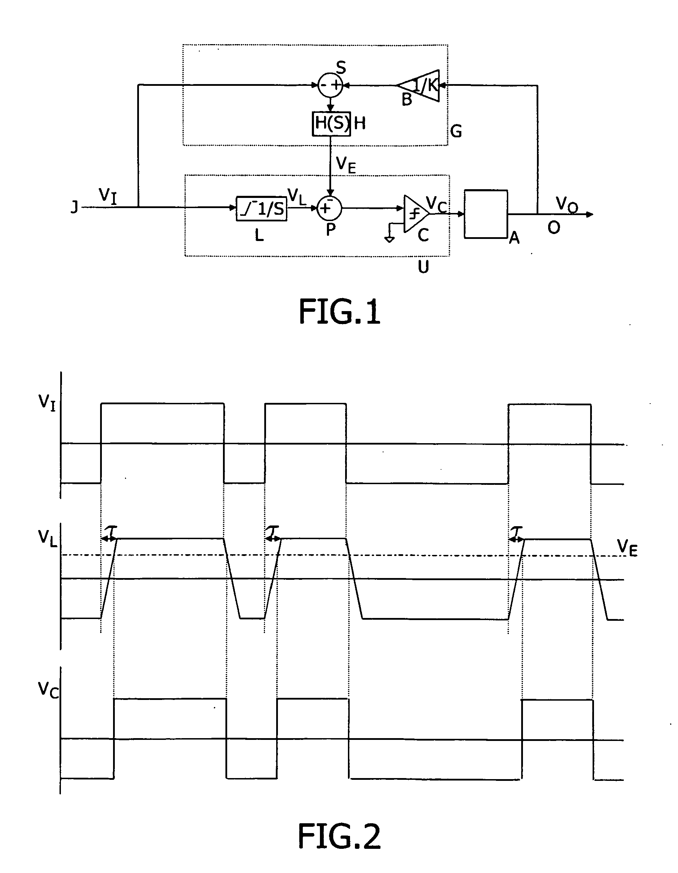

The prior art arrangement of Figure 1 contains an input terminal J to which a PWM input signal V₁ is applied. In this example the input signal is an analog PWM signal. This signal is processed in a reshaping unit U in which a correction of the PWM input signal takes place and whose operation will be explained hereafter. The output signal of this unit drives a class D output stage A whose output O may for instance be coupled through a standard class D low pass filter to one ore more loudspeakers (not shown). In order to reduce the effects of amplitude- and/or timing errors occurring in this output stage the PWM output signal V_{O} of the amplifier A is applied to an error correction signal generator G wherein the output signal V_{O} is firstly attenuated by an attenuator B and subsequently supplied to a subtracter S. In this subtracter the input signal V₁ is subtracted from the attenuated output signal V_{O}. The difference between these two PWM signals is filtered in a low pass filter H with transfer function H(s) to generate an error correction signal V_{E}. The attenuator B in the lead between the output O and the subtracter S serves to compensate the amplification factor K of the amplifier A so that the two PWM-signals in the subtracter S have approximately equal amplitudes.

The integrator/comparator unit U has a limited integrator L to which the PWM input signal is applied and which delivers a limited integrated PWM-signal V_{L}. This signal has less steep edges than the input signal. The slopes of the limited integrated signal V_{L} start with the edges of the input signal and end a fixed time τ later. The signals V₁ and V_{L} are illustrated in Figure 2. In a subtracter P the error signal V_{E} is subtracted from the limited integrated PWM signal V_{L} and the difference is applied to the input of a comparator C. The output signal V_{C} of the comparator is a PWM signal whose edges are shifted with respect to the edges of the input signal V₁ to compensate for both the timing errors and the amplitude errors of the output stage A. As is illustrated in Figure 2 the edges of the signal V_{C} appear at the instants when the limited integrated PWM signal V_{L} and the error signal V_{E} are equal i.e. when the output of the subtracter P is zero. It will be apparent from the signal curves of Figure 2 that the edges of the signal V_{C} cannot be changed over a period larger than the slope period τ of the limited integrated signal V_{L} and that the slope period τ cannot be made larger than the smallest pulse-width in the input signal. Therefore the control range of the prior art arrangement is severely limited.

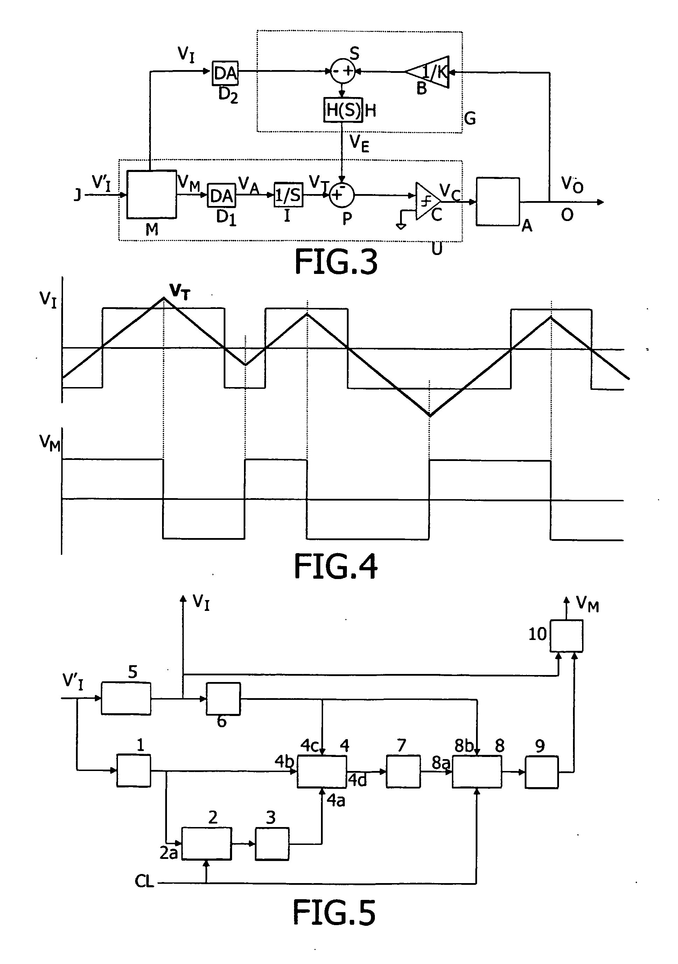

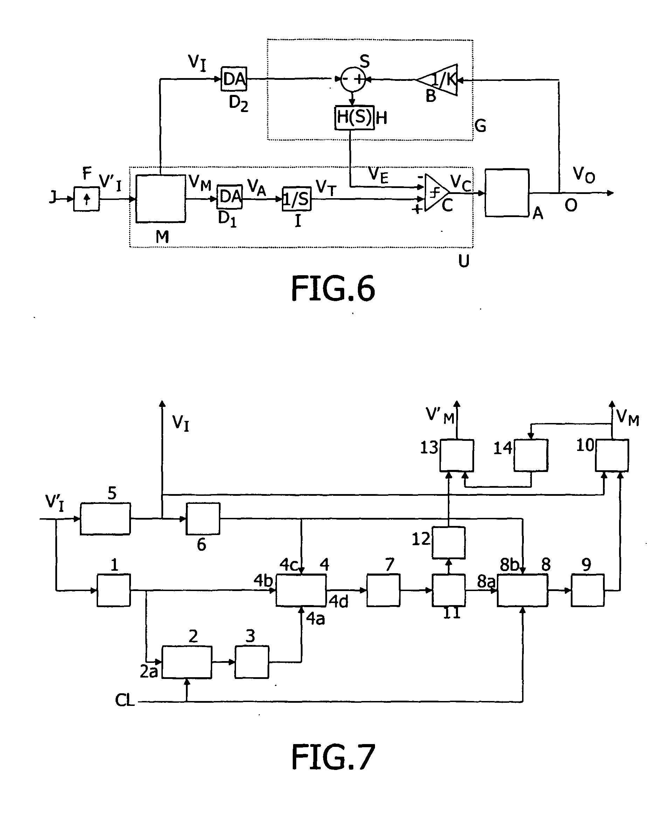

In Figure 3 corresponding elements with those of Figure 1 have been given the same references. The arrangement of this Figure receives a sampled PMW input signal V'₁ that is applied to a pulse-width modifier M. This unit M delivers a PWM signal V₁ that has a fixed delay with respect to the signal V'₁ through a DA converter D₂ to the subtracter S. The signal V₁ serves as input signal to part of the pulse-width modifier M and to the error-correction signal generator G. The pulse-width modifier (M) generates a modified PWM signal V_{M} whose edges coincide with the middle of the pulses of the input signal V₁. This is illustrated by the waveforms of V₁ and V_{M} in Figure 4. In this Figure the downward edges of the signal V_{M} coincide with the middle of the positive pulses of the signal V₁ and the upward edges of V_{M} coincide with the middle of the negative pulses of V₁. Examples of the construction of the pulse-width modifier M will be described with reference to the Figures 5 and 6 of the drawings.

The modified PWM signal V_{M} is fed to a DA-converter D₁ and the analog modified PWM signal V_{A} is subsequently applied to a full integrator I which transforms the modified PWM signal V_{A} into a triangular wave V_{T} as shown by the thick curve in Figure 4. It may be noted that the signal V_{T} is a width modulated triangular wave whose zero crossings coincide with the zero crossings of the PWM input signal V₁. The triangular wave V_{T} is combined with the error correction signal V_{E} in the subtracter P and the so combined signal is fed to the input of the comparator C to obtain the corrected PWM-signal V_{C}. These operations are the same as those explained with reference to Figure 1 and they are not further illustrated in Figure 4. The important difference with respect to the arrangement of Figure 1 is that the slopes of the triangular wave V_{T} occupy more time span than those of the limited integrated signal V_{L} of Figure 2 and that the error correction range of the arrangement of Figure 3 can therefore be much larger than that of the prior art arrangement of Figure 1.

Figure 5 shows an example of a pulse-width modifier M for use in the arrangement of Figure 3. The input signal V'₁ is applied to an edge detector 1. This edge detector may comprise a one-sample delay and a XOR-gate that xor's the input signal with the one-sample delayed input signal. The XOR-gate delivers "zeros" as long as the input sample equals the previous input sample. When an edge in the PWM input signal occurs the actual input sample is unequal to the previous input sample and the XOR-gate delivers a "one". A counter 2 is clocked by a sample-clock CL and has a reset input 2a connected to the output of the edge detector 1. When an edge is detected the counter is reset to the value I and subsequently counts the received samples until a second edge is detected. The value of the count is fed to a one-sample delay 3 that serves to hold the last count when the counter 2 is reset. Therefore, when the edge detector 1 detects a new edge, the count stored in the one-sample delay 3 represents the number of samples of the pulse just finished. A buffer 4 with a data input 4a and a pop-input 4b stores the count from the one-sample delay 3 upon reception of a pulse from the edge detector 1 at its pop-input 4b.

The PWM-input signal V'₁ is delayed in a suitable delay 5 to obtain the PWM signal V₁ for application to the DA converter D₂ of Figure 3. The delayed signal V₁ is also applied to a second edge detector 6. When this second edge detector detects an edge in the delayed input signal V₁, it sends a pulse to a pop-out input 4c of the buffer 4 with the result that the count contained in the buffer is outputted at an output 4d of the buffer. This count is divided by two in a divider 7 and the so divided count is available at an input 8a of a down-counter 8. The pulse of the second edge detector is also applied to a pop-in input 8b of the down-counter and enables the divided count to be stored in the down-counter. Subsequently the down-counter counts down at the rate of the clock pulses CL and, because the value of the count is half the value of the original count in the buffer 4, the down-count operation will be completed in half the period of the pulse. The output of the down-counter 8 is applied to a comparator 9. This comparator produces a "one" at its output when the down-counter is empty which is the case in the middle of the pulse of the (delayed) input signal V₁. The output of the comparator 9 and the delayed PWM input signal V₁ are fed to a XOR-gate 10 to produce the modified PWM signal V_{M}.

It may be observed that the delay 5 should be larger than the largest possible pulse-width, either positive or negative, to prevent that at the time that the buffer 4 is read out it still contains the count of the previous pulse. On the other hand, when the buffer can store only one count, the delay should be smaller than the smallest possible pulse period i.e. the sum of the widths of two consecutive pulses, one positive and one negative pulse, to prevent that, at the time the buffer is read out, it already contains the count of the next pulse. Therefore the pulse period should be constant. On the other hand, if the buffer 4 can contain a plurality of count values, and is organized on a first-in first-out basis, also PWM signals with variable pulse period, such as PWM noise shaped signals, can be handled. In this case the delay has to be larger than the largest possible pulse-width and the buffer-size i.e. the number of counts that can be stored in the buffer, has to be larger than twice the delay divided by the smallest possible pulse period.

The pulse-width modifier of Figure 5 operates only correctly when each pulse of the PWM input signal has an even number of samples. In that case each edge of the output signal V_{M} of the pulse-width modifier lies exactly in the middle of a pulse of the PWM input signal with half of the samples of the input pulse lying before said edge and the other half of the samples lying behind said edge. However, each pulse of the input signal with an odd number of samples results in an error in the output signal of the pulse-width modifier and also in the triangular wave derived there from.

A solution to this problem is shown in Figure 6. In the arrangement according to this Figure an upsampler F with an up-sampling ratio of 2 is inserted in front of the arrangement, so that the number of samples of all the pulses of the input signal is doubled and any pulse with odd number of samples is avoided while the mutual relationship of all pulses remains unchanged.

The arrangement of Figure 6 also illustrates that the subtracter P of the arrangement of Figure 6 can be deleted by using a differential comparator C. One input of the comparator C is used for the triangular signal V_{T} and the other input for the error correction signal V_{E}.

If the use of the upsampler F in Figure 6 would lead to an unacceptably or undesirably high sample frequency, the problem of the odd number of samples in a pulse may be solved with the pulse-width modifier of Figure 7. In this Figure the elements corresponding to those of Figure 5 have the same reference numerals and need no further explanation.

In this pulse-width modifier the output of the divider 7 is applied to a splitter 11 that splits the divided count in an integer part and a fractional part. The integer part is applied to the input 8a of the down-counter 8 in the same way as in the pulse-width modifier of Figure 5. The fractional part, which is equal to 0 when the counted pulse has an even number of samples and equal to 0,5 when the pulse has an odd number of samples, is applied to a multiplier 12 that multiplies by 2 and consequently delivers a single bit 0 or 1 dependent upon whether the pulse count is even or odd respectively. This single bit is applied to one input of an AND-gate 13. The other input of this AND-gate is connected to a third edge detector 14 that detects the edges in the output V_{M} of the XOR-gate 10. Therefore the output V'_{M} of the AND-gate 13 is always 0 except when the edge detector 14 detects an edge in the modified output signal V_{M} and the fractional part of the divided count is not zero. The two single bit signals V_{M} and V'_{M} control a two-bit DA-converter, which replaces the one-bit DA-converter D1 of Figures 3 and 6. This two-bit DA-converter is so designed that the output signal V_{A} of this DA-converter is:
1 if V_{M} = 1 and V'_{M} = 0
-1 if V_{M} = 0 and V'_{M} = 0
0 if V'_{M} = 1

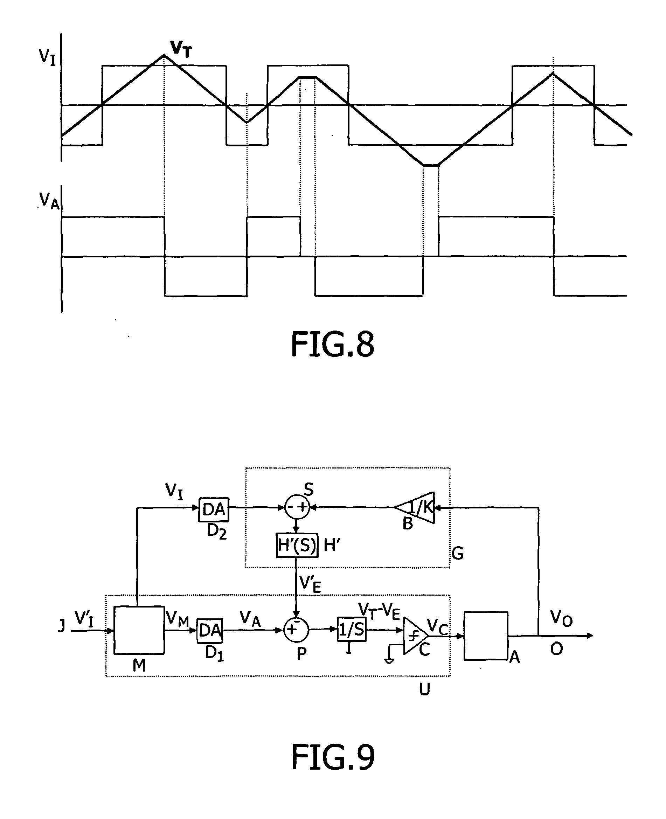

Figure 8 shows the input signal V₁, the output signal V_{A} of the two-bit DA-converter D1 and the output V_{T} of the integrator I. In this Figure it is assumed that the 3^{rd} and the 4^{th} pulses of the input signal have an odd number of samples while the 1^{st}, the 2^{nd} and the 5^{th} pulses have an even number of samples.

The arrangement of Figure 9 corresponds to that of Figure 3 except in that the integrator I is connected in the output lead of the subtracter P instead of in its + input lead. It is hereby assumed that the low pass filter H for low pass filtering the error correction signal in Figure 3 comprises at least one integrator section. This integrator section and the integrator I of Figure 3 may then be replaced by a single integrator in the output lead of the subtracter P. The low pass filter H' of Figure 9 is equal to the low pass filter H of Figure 3 minus one integrator section. The subtracter P subtracts the insufficiently low-pass filtered error correction signal V'_{E} from the modified PWM signal V_{A} and the integrator I supplies the combination of the triangular wave V_{T} and the sufficiently low pass filtered error correction signal V_{E} to the input of the comparator C.

The embodiments of the present invention shown in the Figures and described above are intended to be taken in an illustrative and not a limiting sense. Those skilled in the art may make various modifications to these embodiments without departing from the scope of the present invention as defined in the appended claims. For example when in the arrangement of Figure 3 the attenuator B inverts the signal V_{O} then both combiners S and P will become adders instead of subtracters.

## Claims

1. Arrangement for amplifying a PWM input signal (V₁), said arrangement comprising a class D output stage (A), an error correction signal generator (G) arranged to compare a PWM output signal (V_{O}) of the class D output stage with the PWM input signal (V₁) and to supply an error correction signal (V_{E}) resulting from this comparison and reshaping means (U) arranged to receive the PWM input signal (V₁) and the error correction signal (V_{E}) and to supply a reshaped PWM signal (V_{C}) to the input of the class D output stage, **characterized in that** the reshaping means derive from the PWM input signal (V₁,V₁') a width modulated triangular wave (V_{T}) whose zero-crossings, at zero error correction signal, substantially coincide with the edges of the PWM input signal and that the triangular wave and the error correction signal drive a comparator that delivers the said reshaped PWM signal (V_{C}).

2. Arrangement for amplifying a PWM input signal as claimed in claim 1 **characterized in that** the control loop comprising the class D output stage (A), the error correction generator (G) and the comparator (C) is implemented by analog means while the generation of the triangular wave (V_{T}) is implemented, wholly or partly, by digital means (M).

3. Arrangement for amplifying a PWM input signal as claimed in claim 2 **characterized in that** the reshaping means comprise a pulse-width modifier (M) receiving the PWM input signal, generating a modified PWM signal (V_{M}) whose edges substantially lie in the middle between the edges of the PWM input signal (V₁) and supplying the modified PWM signal (V_{M}) through a DA-converter (D₁) to an analog integrator (I) that provides full integration of the modified PWM signal (V_{M}).

4. Arrangement as claimed in claim 3 **characterized in that** the error correction signal (V'_{E}) and the modified PWM signal (V_{A}) are both applied to a combiner (P), that the output signal of this combiner is applied to an integrator (I) and that the output of the integrator (I) comprises the combination of the triangular wave (V_{T}) and the error correction signal (V_{E}) for driving the comparator (C).

5. Arrangement as claimed in claim 3 receiving a sampled PWM input signal **characterized in that** the pulse-width modifier (M) is arranged to determine the middle of a width modulated pulse by counting (2) the samples during said pulse, storing (4) the count thereby obtained and down-counting (8) said count at twice the rate of the samples.

6. Arrangement as claimed in claim 3 receiving a sampled PWM input signal **characterized in that** the pulse-width modifier (M) is arranged to determine the middle of a width modulated pulse by counting (2) the samples during said pulse, storing (4) the count thereby obtained, dividing (7) said count by two and down-counting (8) the divided count at the rate of the samples.

7. Arrangement as claimed in claim 5 or 6 **characterized by** an upsampler (F) for doubling the sampling of the PWM input signal (V₁) that is to the pulse-width modifier (M).

8. Arrangement as claimed in claim 5 or 6 **characterized in that** the pulse-width modifier (M) is arranged to provide a modified PWM signal (V_{A}) varying between +1 and -1 values, **in that** a splitter (11) is provided to split the stored count into an integer part and a fractional part of 0,5 and means (12,13) to use the fractional part to set the modified PWM signal (V_{A}) to zero when the multiplied fractional part is 0,5.

## Patentansprüche

1. Anordnung zum Verstärken eines PWM-Eingangssignals (V₁), wobei die Anordnung eine Klasse-D-Ausgangsstufe (A), einen Fehlerkorrektursignal-Generator (G), der eingerichtet ist, um ein PWM-Ausgangssignal (V_{O}) der Klasse-D-Ausgangsstufe mit dem PWM-Eingangssignal (V₁) zu vergleichen und um ein Fehlerkorrektursignal (V_{E}) zu liefern, das aus diesem Vergleich resultiert, und Regenerierungsmittel (U) umfasst, die eingerichtet sind, um das PWM-Eingangssignal (V₁) und das Fehlerkorrektursignal (V_{E}) zu empfangen und um ein regeneriertes PWM-Signal (V_{C}) an den Eingang der Klasse-D-Ausgangsstufe zu liefern, **dadurch gekennzeichnet, dass** die Regenerierungsmittel von dem PWM-Eingangssignal (V₁, V'₁) eine breitenmodulierte Dreieckwelle (V_{T}) ableiten, deren Nulldurchgänge am Nullpunktabweichungs-Korrektursignal im Wesentlichem mit den Flanken des PWM-Eingangssignals übereinstimmen, und dass die Dreieckwelle und das Fehlerkorrektursignal einen Komparator steuern, der das regenerierte PWM-Signal (V_{C}) liefert.

2. Anordnung zum Verstärken eines PWM-Eingangssignals nach Anspruch 1, **dadurch gekennzeichnet, dass** die Regelschleife, die die Klasse-D-Ausgangsstufe (A), den Fehlerkorrekturgenerator (G) und den Komparator (C) umfasst, durch analoge Mittel ausgeführt ist, während die Erzeugung der Dreieckwelle (V_{T}) ganz oder teilweise durch digitale Mittel (M) ausgeführt wird.

3. Anordnung zum Verstärken eines PWM-Eingangssignals nach Anspruch 2, **dadurch gekennzeichnet, dass** die Regenerierungsmittel einen Impulsbreitenwandler (M) umfassen, der das PWM-Eingangssignal empfängt, ein umgewandeltes PWM-Signal (V_{M}) erzeugt, dessen Flanken im Wesentlichen in der Mitte zwischen den Flanken des PWM-Eingangssignals (V₁) liegen, und das umgewandelte PWM-Signal (V_{M}) durch einen DA-Wandler (D_{I}) an einen analogen Integrator (I) liefert, der eine vollständige Integration des umgewandelten PWM-Signals (V_{M}) bereitstellt.

4. Anordnung nach Anspruch 3, **dadurch gekennzeichnet, dass** das Fehlerkorrektursignal (V'_{E}) und das umgewandelte PWM-Signal (V_{A}) beide an einen Kombinator (P) angelegt werden, dass das Ausgangssignal dieses Kombinators an einen Integrator (I) angelegt wird, und dass der Ausgang des Integrators (I) die Kombination der Dreieckwelle (V_{T}) und des Fehlerkorrektursignals (V_{E}) zum Steuern des Komparators (C) umfasst.

5. Anordnung nach Anspruch 3, die ein abgetastetes PWM-Eingangssignal empfängt, **dadurch gekennzeichnet, dass** der Impulsbreitenwandler (M) eingerichtet ist, um durch Zählen (2) der Abtastungen während des Impulses, Speichern (4) der dabei erhaltenen Zählung und Rückwärtszählen (8) der Zählung bei der doppelten Rate der Abtastungen die Mitte eines breitenmodulierten Impulses zu bestimmen.

6. Anordnung nach Anspruch 3, die ein abgetastetes PWM-Eingangssignal empfängt, **dadurch gekennzeichnet, dass** der Impulsbreitenwandler (M) eingerichtet ist, um durch Zählen (2) der Abtastungen während des Impulses, Speichern (4) der dabei erhaltenen Zählung, Dividieren (7) dieser Zählung durch zwei und Rückwärtszählen (8) der dividierten Zählung bei der Rate der Abtastungen die Mitte eines breitenmodulierten Impulses zu bestimmen.

7. Anordnung nach Anspruch 5 oder 6, **gekennzeichnet durch** einen Upsampler (F) zum Verdoppeln der Abtastung des PWM-Eingangssignals (V₁), das an den Impulsbreitenwandler (M) angelegt wird.

8. Anordnung nach Anspruch 5 oder 6, **dadurch gekennzeichnet, dass** der Impulsbreitenwandler (M) eingerichtet ist, um ein umgewandeltes PWM-Signal (V_{A}) bereitzustellen, das zwischen den Werten +1 und -1 variiert, dadurch**,** dass ein Splitter (11), um die gespeicherte Zählung in einen ganzzahligen Anteil und einen gebrochenen Anteil von 0,5 zu unterteilen, und Mittel (12, 13) zur Verwendung des gebrochenen Anteils bereitgestellt werden, um das umgewandelte PWM-Signal (V_{A}) nullzustellen, wenn der multiplizierte gebrochene Anteil 0,5 beträgt.

## Revendications

1. Dispositif d'amplification d'un signal d'entrée de modulation d'impulsion en largeur (V₁), ledit dispositif comprenant un étage de sortie classe D (A), un générateur de signal de correction d'erreur (G) prévu pour comparer un signal de sortie de modulation d'impulsion en largeur (V_{O}) de l'étage de sortie classe D avec le signal d'entrée de modulation d'impulsion en largeur (V₁) et pour fournir un signal de correction d'erreur (V_{E}) découlant de cette comparaison et des moyens de reformage (U) prévus pour recevoir le signal d'entrée de modulation d'impulsion en largeur (V₁) et le signal de correction d'erreur (V_{E}) et pour fournir un signal de modulation d'impulsion en largeur reformé (V_{C}) à l'entrée de l'étape de sortie classe D, **caractérisé en ce que** les moyens de reformage découlent du signal d'entrée de modulation d'impulsion en largeur (V₁, V_{1'}), une onde triangulaire modulée en largeur (V_{T}) dont les croisements zéro, au signal de correction d'erreur zéro, coïncident sensiblement avec les bords du signal d'entrée de modulation d'impulsion en largeur, et **en ce que** l'onde triangulaire et le signal de correction d'erreur attaquent un comparateur qui fournit ledit signal de modulation d'impulsion en largeur reformé (V_{C}).

2. Dispositif d'amplification d'un signal d'entrée de modulation d'impulsion en largeur tel que revendiqué dans la revendication 1, **caractérisé en ce que** la boucle de commande comprenant l'étape de sortie classe D (A), le générateur de correction d'erreur (G) et le comparateur (C) est mise en oeuvre par des moyens analogiques, tandis que la génération de l'onde triangulaire (V_{T}) est mise en oeuvre, totalement ou partiellement, par des moyens numériques (M).

3. Dispositif d'amplification d'un signal d'entrée de modulation d'impulsion en largeur tel que défini dans la revendication 2, **caractérisé en ce que** les moyens de reformage comprennent un modificateur de largeur d'impulsion (M) recevant le signal d'entrée de modulation d'impulsion en largeur, modifiant un signal de modulation d'impulsion en largeur modifié (V_{M}) dont les bords se situent sensiblement au centre, entre les bords du signal d'entrée de modulation d'impulsion en largeur (V₁), et fournissant le signal de modulation d'impulsion en largeur modifié (V_{M}) par le biais d'un convertisseur numérique analogique (D₁) à un intégrateur analogique (I) qui fournit l'intégration totale du signal de modulation d'impulsion en largeur modifié (V_{M}).

4. Dispositif tel que revendiqué dans la revendication 3, **caractérisé en ce que** le signal de correction d'erreur (V'_{E}) et le signal de modulation d'impulsion en largeur modifié (V_{A}) sont tous deux appliqués à un combinateur (P), **en ce que** le signal de sortie de ce combinateur est appliqué à un intégrateur (I) et **en ce que** la sortie de l'intégrateur (I) comprend la combinaison de l'onde triangulaire (V_{T}) et le signal de correction d'erreur (V_{E}) pour attaquer le comparateur (C).

5. Dispositif tel que revendiqué dans la revendication 3, recevant un signal d'entrée de modulation d'impulsion en largeur échantillonné, **caractérisé en ce que** le modificateur de largeur d'impulsion (M) est prévu pour déterminer le centre d'une impulsion modulée en largeur, en comptant (2) les échantillons pendant ladite impulsion, en stockant (4) le comptage ainsi obtenu et en décomptant (8) ledit comptage à raison de deux fois la vitesse des échantillons.

6. Dispositif tel que revendiqué dans la revendication 3, recevant un signal d'entrée de modulation d'impulsion en largeur échantillonné, **caractérisé en ce que** le modificateur de largeur d'impulsion (M) est prévu pour déterminer le centre d'une impulsion modulée en largeur, en comptant (2) les échantillons au cours de ladite impulsion, en stockant (4) le comptage ainsi obtenu, en divisant (7) ledit comptage par deux et en décomptant (8) le comptage divisé à raison de la vitesse des échantillons.

7. Dispositif tel que défini dans la revendication 5 ou 6, **caractérisé par** un échantillonneur ascendant (F) pour doubler l'échantillonnage du signal d'entrée de modulation d'impulsion en largeur (V₁), c'est-à-dire au modificateur de largeur d'impulsion (M).

8. Dispositif tel que défini dans la revendication 5 ou 6, **caractérisé en ce que** le modificateur de largeur d'impulsion (M) est prévu pour fournir un signal de modulation d'impulsion en largeur modifié (V_{A}) variant entre des valeurs de +1 et de -1, **en ce qu'**un fractionneur (11) est prévu pour fractionner le comptage stocké en une partie d'intégrateur et en une partie fractionnelle de 0,5 et des moyens (12, 13) pour utiliser la partie fractionnelle pour mettre à zéro le signal de modulation d'impulsion en largeur modifié (V_{A}) lorsque la partie fractionnelle multipliée est égale à 0,5.
